# EUROPEAN PATENT APPLICATION

(11) **EP 4 679 507 A1**
(43) Date of publication of application: **14.01.2026**
(21) Application number: 24767326.2
(22) Date of filing: 27.02.2024
(51) Int. Cl.: H01L 33/02, H01L 33/14, H01L 33/22, H01L 33/38, H01L 33/58, H01L 33/62, H01L 33/46, H01L 33/52, H01L 25/16, H01L 25/075

(54) **LIGHT-EMITTING MODULE AND SYSTEM INCLUDING SAME**

(30) Priority: 06.03.2023 US 202363450199 P; 24.04.2023 US 202363461365 P; 23.02.2024 US 202418585828
(71) Applicant: Seoul Viosys Co., Ltd., Ansan-si, Gyeonggi-do 15429 (KR)
(72) Inventor: CHOI, Hyo Shik, Ansan-Si Gyeonggi-do 15429 (KR)
(74) Representative: Stolmár & Partner Patentanwälte PartG mbB
(86) International application number: PCT/KR2024/002502
(87) International publication number: WO 2024/186037

(57) **Abstract**

A light emitting module is disclosed.

The light emitting module includes a light emitting device, and the light emitting device including: a substrate; a first window layer supplying electrons; a second window layer supplying holes; an active layer disposed between the first window layer and the second window layer; a first ohmic electrode electrically connected to the first window layer; and a second ohmic electrode electrically connected to the second window layer, wherein the first window layer includes a first high-level doped layer having a higher doping level applied than other portions thereof and wherein the first ohmic electrode is electrically connected to the first high-level doped layer.

## Description

### [Technical Field]

The present invention relates to a light emitting module realizing colors and a light emitting system including the same.

### [Background Art]

A light emitting diode (LED) is one of light emitting devices emitting light upon application of electric current thereto. The light emitting diode is formed by growing epitaxial layers on a substrate and includes an N-type semiconductor layer, a P-type semiconductor layer, and an active layer interposed therebetween. An N-electrode pad is formed on the N-type semiconductor layer and a P-electrode pad is formed on the P-type semiconductor layer, and the light emitting diode is electrically connected to an external power source through the electrode pads and driven. Here, electric current flows from the P-electrode pad to the N-electrode pad through the semiconductor layers.

On the other hand, in order to prevent light loss by the P-electrode pad while improving heat dissipation efficiency, a flip-chip type light emitting diode is used and various electrode structures are suggested to assist in current spreading in a large-area flip-chip type light emitting diode. For example, a reflective electrode is formed on the P-type semiconductor layer and extensions for current spreading are formed in an exposed region of the N-type semiconductor layer exposed by etching the P-type semiconductor layer and the active layer.

A display apparatus employing light emitting diodes may be obtained by forming structures of red (R), green (G) and blue (B) light emitting diodes (LEDs) individually grown on a final substrate.

### [Disclosure]

### [Technical Problem]

The present invention relates to a light emitting module and a light emitting system including the same. The present invention may be employed as a light source by various devices.

### [Technical Solution]

In accordance with to one aspect of the present invention, a light emitting module includes a light emitting device, and the light emitting device including: a substrate; a first window layer supplying electrons; a second window layer supplying holes; an active layer disposed between the first window layer and the second window layer; a first ohmic electrode electrically connected to the first window layer; and a second ohmic electrode electrically connected to the second window layer, wherein the first window layer includes a first high-level doped layer having a higher doping level applied than other portions thereof and wherein the first ohmic electrode is electrically connected to the first high-level doped layer.

The doping level of the first high-level doped layer electrically connected to the first ohmic electrode may be 4e18 atoms/cm³ or more.

The light emitting module may further include a contact layer disposed between the second window layer and the second ohmic electrode, wherein the second ohmic electrode is contacted to the contact layer.

The light emitting module may further include a first cladding layer disposed between the first window layer and the active layer to prevent the holes from crossing over into the first window layer.

The light emitting module may further include at least one of a first electron regulation layer disposed between the first window layer and the active layer to regulate a speed at which the electrons reach the active layer or a first hole regulation layer disposed between the active layer and the second window layer to regulate a speed at which the holes reach the active layer.

Group **III** and group V elements constituting the first electron regulation layer may be the same as group **III** and group V elements constituting the first hole regulation layer.

The light emitting module may further include a second cladding layer disposed between the active layer and the second window layer to prevent the electrons from crossing over into the second window layer.

An area of the first window layer may be 0.7 to 1 times an area of the substrate.

The light emitting module may include a plurality of light emitting devices, wherein the plurality of light emitting devices may have respective peak wavelengths and a deviation between the respective peak wavelengths may be 5 nm or less.

In accordance with another aspect of the present invention, a light emitting module includes: a substrate; a plurality of light emitting devices disposed on the substrate, the plurality of light emitting devices including: a first light emitting device including an active layer generating light having a peak wavelength of 600 nm or more; a second light emitting device including an active layer generating light having a peak wavelength of less than 500 nm; a third light emitting device emitting light having a peak wavelength between the peak wavelength of the first light emitting device and the peak wavelength of the second light emitting device, wherein group V elements constituting the first light emitting device are different from group V elements of the second and third light emitting devices, and wherein a direction in which electrons are supplied to the active layer in the first light emitting device is the same as a direction in which electrons are supplied to the active layer in the second light emitting device.

The light emitting module may further include a reflective layer disposed on the substrate, wherein the reflective layer is disposed around a periphery of at least some region of the plurality of light emitting devices and has a reflectivity of 80% or more with respect to the peak wavelengths of light emitted from the plurality of light emitting devices.

Each of the light emitting devices may further include a support substrate supporting the corresponding light emitting device and light of different peak wavelengths emitted from the light emitting devices may be emitted through the corresponding support substrates formed of the same material.

The light emitting module may further include a molding layer including a light exit surface and covering the plurality of light emitting devices, and distances from the plurality of support substrates to the light exit surface may be different from each other.

The light emitting module may further include an IC circuit or IC driver, wherein the IC circuit or the IC driver is electrically connected to the plurality of light emitting devices and covered by the molding layer simultaneously with the plurality of light emitting devices.

A height from an upper surface of the IC circuit or the IC driver to the light exit surface of the molding layer may be different from a height from upper surfaces of the plurality of light emitting devices to the light exit surface of the molding layer, and the molding layer may compensate for height difference such that the light exit surface is placed at the same location.

At least one of the light emitting devices may include at least one light transmissive material disposed between the light emitting device and the support substrate to change an index of refraction.

The direction in which electrons are supplied to the active layer in the second light emitting device may be the same as a direction in which electrons are supplied to the active layer in the third light emitting device.

A first type dopant material of the plurality of light emitting devices may include at least one identical material.

The first light emitting device may include a first electron regulation layer disposed on one side of the active layer of the first light emitting device; and a first hole regulation layer disposed on the other side of the active layer of the first light emitting device, and group **III** and group V elements constituting the first electron regulation layer may be the same as group **III** and group V elements constituting the first hole regulation layer.

The plurality of light emitting devices may be individually controllable.

### [Advantageous Effects]

According to the present invention, a texturing process may be performed on a lower surface of the first window layer, whereby the light emitting device can improve luminous efficacy by texturing.

According to the present invention, even light emitting devices of red-series have the same mesa direction as light emitting devices emitting other colors, thereby securing convenience in circuit construction.

According to one embodiment of the present invention, the light emitting devices are formed over the entire plane of the light emitting module, whereby the light emitting module can be advantageously used as a single-color high brightness light source.

According to the present invention, a user can freely select and arrange different kinds of light emitting modules, as needed.

### [Description of Drawings]

FIG. 1 is a schematic plan view of a light emitting module according to a first embodiment of the present invention.
FIG. 2 is a schematic plan view of a first window layer of the light emitting module according to the first embodiment shown in FIG. 1.
FIG. 3 is a schematic plan view of a mesa of the light emitting module according to the first embodiment shown in FIG. 1.
FIG. 4 is a schematic plan view of a second ohmic electrode of the light emitting module according to the first embodiment shown in FIG. 1.
FIG. 5 is a schematic plan view of a first ohmic electrode of the light emitting module according to the first embodiment shown in FIG. 1.
FIG. 6 is a schematic plan view of an insulating layer of the light emitting module according to the first embodiment shown in FIG. 1.
FIG. 7 is a schematic plan view of bumps of the light emitting module according to the first embodiment shown in FIG. 1.
FIG. 8 is a schematic plan view of an electrode pad of the light emitting module according to the first embodiment shown in FIG. 1.
FIG. 9 is a schematic cross-sectional view of the light emitting module according to the first embodiment taken along A-A' in FIG. 1.
FIG. 10 is a graph showing a composition of each layer while etching, one layer by one layer, a light emitting device according to the first embodiment of the present invention.
FIGS. 11a to 11m are cross-sectional views sequentially illustrating a method of manufacturing the light emitting device according to the first embodiment of the present invention.
FIG. 11n is a schematic cross-sectional view of a light emitting module according to another embodiment of the present invention.
FIG. 11o is a schematic cross-sectional view of a light emitting module according to a further embodiment of the present invention.
FIG. 12 is a schematic plan view of light emitting modules according to second to fourth embodiments of the present invention.
FIG. 13 is a schematic cross-sectional view of the light emitting modules according to the second to fourth embodiments taken along B-B' in FIG. 12.
FIG. 14a is a schematic plan view of a light emitting module according to yet another embodiment of the present invention.
FIG. 14b is a schematic cross-sectional view of the light emitting module taken
along B-B' in FIG. 14a.

### [Detailed Description]

In the following description, for the purposes of explanation, numerous specific details are set forth in order to provide thorough understanding of various exemplary embodiments or implementations of the present disclosure. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is implemented differently, a specific process order may be performed differently from the described order. For example, two consecutively described processes may be performed substantially at the same time or performed in an order opposite the described order. In addition, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the x, y, and z-axes, and may be interpreted in a broader sense. For example, the DR1-axis, the DR2-axis, and the DR3-axis may be perpendicular to one another, or may represent different directions that are not perpendicular to one another. For the purposes of this disclosure, "at least one of X, Y, or Z" and "at least one selected from the group consisting of X, Y, or Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," or the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), or the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, or the like, which may be formed using semiconductor-based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

Hereinafter, exemplary embodiments of the present invention will be described in detail with reference to the accompanying drawings.

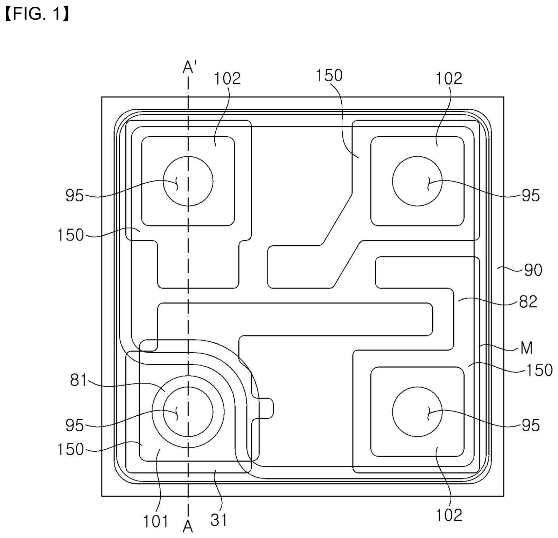

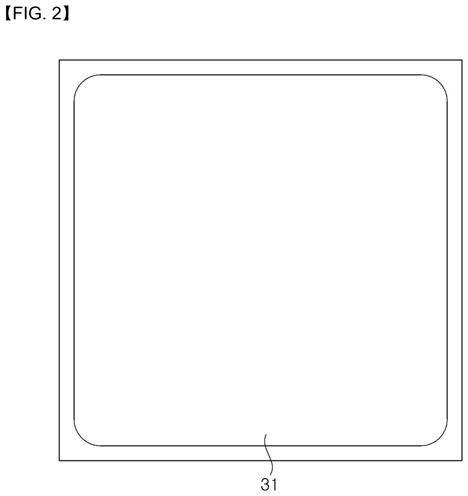

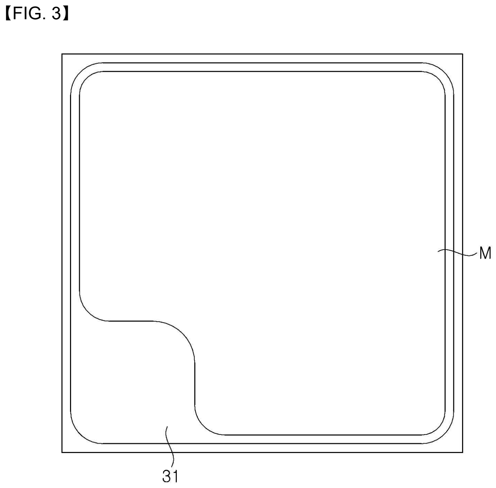

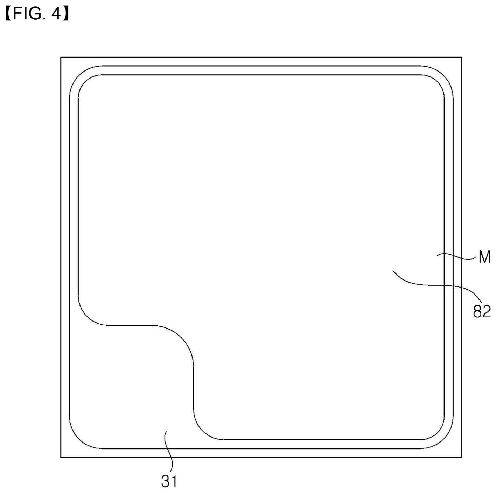

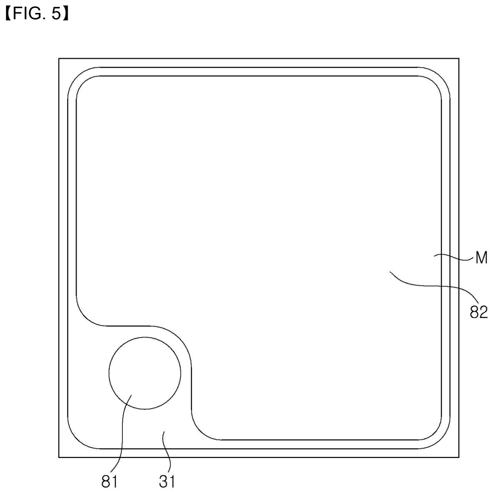

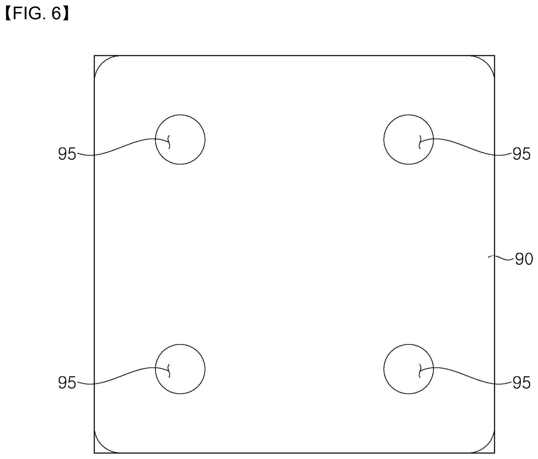

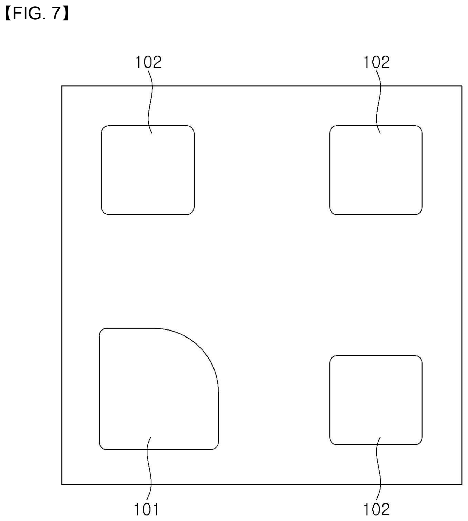

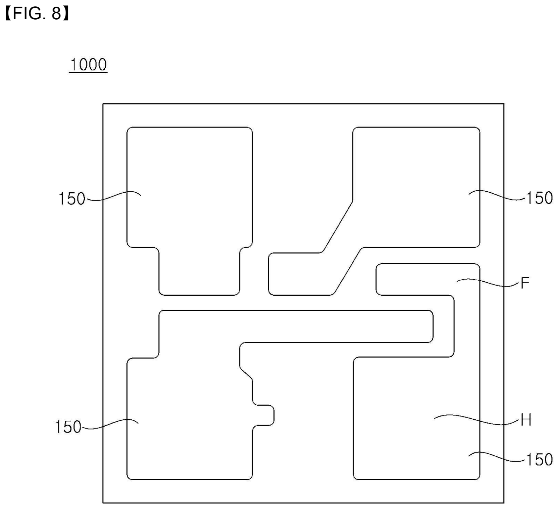

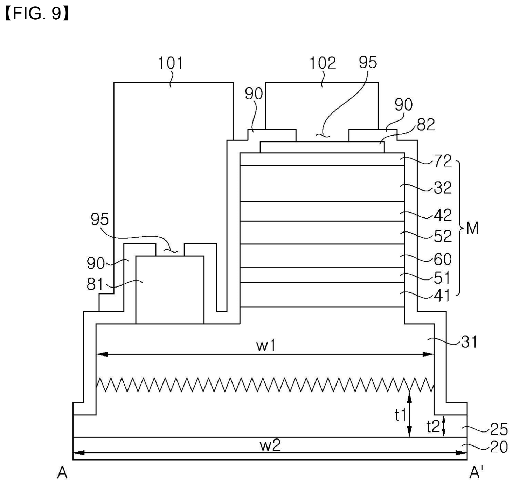

FIG. 1 is a schematic plan view of a light emitting module according to a first embodiment of the present invention, FIG. 2 is a schematic plan view of a first window layer 31 of the light emitting module according to the first embodiment shown in FIG. 1, FIG. 3 is a schematic plan view of a mesa M of the light emitting module according to the first embodiment shown in FIG. 1, FIG. 4 is a schematic plan view of a second ohmic electrode 82 of the light emitting module according to the first embodiment shown in FIG. 1, FIG. 5 is a schematic plan view of a first ohmic electrode 81 of the light emitting module according to the first embodiment shown in FIG. 1, FIG. 6 is a schematic plan view of an insulating layer 90 of the light emitting module according to the first embodiment shown in FIG. 1, FIG. 7 is a schematic plan view of bumps 101, 102 of the light emitting module according to the first embodiment shown in FIG. 1, FIG. 8 is a schematic plan view of an electrode pad 150 of the light emitting module according to the first embodiment shown in FIG. 1, and FIG. 9 is a schematic cross-sectional view of the light emitting module according to the first embodiment taken along A-A' in FIG. 1.

Referring to FIG. 1 to FIG. 9, the light emitting module according to the first embodiment of the present invention includes the light emitting device including a first light transmitting layer 20, a first window layer 31 disposed on the first light transmitting layer 20, an active layer 60 disposed on the first window layer 31, a second window layer 32 disposed on the active layer 60, a second ohmic electrode 82 disposed on the second window layer 32, and a first ohmic electrode 81 disposed on the first window layer 31.

In addition, the light emitting device according to the first embodiment of the present invention may further include at least one of a second light transmitting layer 25 disposed between the first light transmitting layer 20 and the first window layer 31, a first cladding layer 41 and a first electron regulation layer 51 disposed between the first window layer 31 and the active layer 60, a first hole regulation layer 52 and a second cladding layer 42 disposed between the active layer 60 and the second window layer 32, a contact layer 72 disposed between the second window layer 32 and the second ohmic electrode 82, an insulating layer 90 covering an exposed surface of the light emitting device, a first bump 101 disposed on the first ohmic electrode 81, or a second bump 102 disposed on the second ohmic electrode 82.

Referring to FIG. 2 and FIG. 9, the first window layer 31 according to this embodiment may have a planar shape corresponding to a planar shape of the first light transmitting layer 20, in which each corner is a rounded corner. In addition, the first window layer 31 may have a smaller planar area than the first light transmitting layer 20.

Referring to FIG. 3 and FIG. 9, the mesa M according to this embodiment may have a planar shape in which at least a portion of one side or one corner is depressed in a shape corresponding to the planar shape of the first window layer 31 and each corner is a rounded corner. Further, the mesa M may have a smaller planar area than the first window layer 31. The mesa M may include a light emitting region that substantially contributes to light emission.

Referring to FIG. 4 and FIG. 9, the second ohmic electrode 82 according to this embodiment may have a planar shape in which one corner is recessed inwards corresponding to the planar shape of the mesa M and each corner is rounded in at least some region thereof. The second ohmic electrode 82 may have a smaller planar area than the mesa M. The second ohmic electrode 82 may be disposed inside an outer boundary region of the mesa M. The second ohmic electrode 82 may be formed of a light reflective material or a light transmissive material. The light reflective material may include at least one of materials having reflective properties with respect to at least some components of light, such as Ge, Al, Cu, Ag, Au, Ni, Cr, Ti, Pt, Rd, Ru, W, Mo, TiW, and the like, and the light transmissive material may include at least one of materials having transmissive properties with respect to at least some components of light, such as ITO, ZnO, and the like.

Referring to FIG. 5 and FIG. 9, the first ohmic electrode 81 according to this embodiment may be disposed on the first window layer 31 so as to be at least partially enclosed in a recessed portion in the planar shape of the mesa M and the second ohmic electrode 82. The planar shape of the first ohmic electrode 81 may be a circular, elliptical, or rectangular shape, without being limited thereto.

Referring to FIG. 6 and FIG. 9, the insulating layer 90 according to this embodiment may have a planar shape corresponding to the planar shape of the first light transmitting layer 20, in which each corner is a rounded corner. Alternatively, the insulating layer 90 may cover all of the corners of the first light transmitting layer 20. In addition, a horizontal distance from one end of the insulating layer 90 to the other end thereof may be the same as a distance from one end of the first light transmitting layer 20 to the other end thereof. Further, the insulating layer 90 may have a planar area corresponding to the planar area of the first light transmitting layer 20. The insulating layer 90 is formed with a plurality of openings 95, for example, four openings 95 formed in quadrants of the insulating layer 90, respectively. The first and second ohmic electrodes 81, 82 are electrically connected to the first and second bumps 101, 102 through the openings 95 formed in the insulating layer 90, respectively. The insulating layer 90 may be formed of a light transmissive material or a material having oxide film properties. For example, the insulating layer 90 may be formed of a material, such as SiO₂, TiO₂, AlOₓ, or NiOₓ.

Referring to FIG. 7 and FIG. 9, the light emitting module according to this embodiment may include a plurality of bumps 101, 102, specifically a first bump 101 connected to the first ohmic electrode 81 and a second bump 102 connected to the second ohmic electrode 82. For example, one first bump 101 and three second bumps 102 may be disposed at four corners, respectively. However, it should be understood that the present invention is not limited thereto and the light emitting module may include at least one second bump 102. The first bump 101 may have a planar shape in which one corner has a smaller curvature than the other corners and the second bump 102 may have a square or rectangular planar shape, without being limited thereto. Further, the planar shapes of the first bump 101 and the second bump 102 may be rounded at each corner.

Referring to FIG. 8 and FIG. 9, the light emitting module according to this embodiment may include a module substrate 1000 including a plurality of electrode pads 150 electrically connected to the plurality of bumps 101, 102, respectively. The light emitting module according to this embodiment can realize a high brightness display by allowing current injection multiple times (for example, 3 times in the case where three bumps having the same electrical polarity are connected) in a conventional driver through a plurality of electrical connections. At least some of the plurality of electrode pads 150 may include a finger portion F extending from a main portion H of the electrode pad 150 such that at least one extended finger portion F may be disposed to face a center of the light emitting module. The finger portion F may have a different width or length from the width or length of the main portion H. Further, the main portions H of the electrode pads 150 may include the finger portions F, respectively, and the respective finger portions F may be spaced apart from each other. Further, at least two finger portions F may be spaced apart from each other in an interlocking shape.

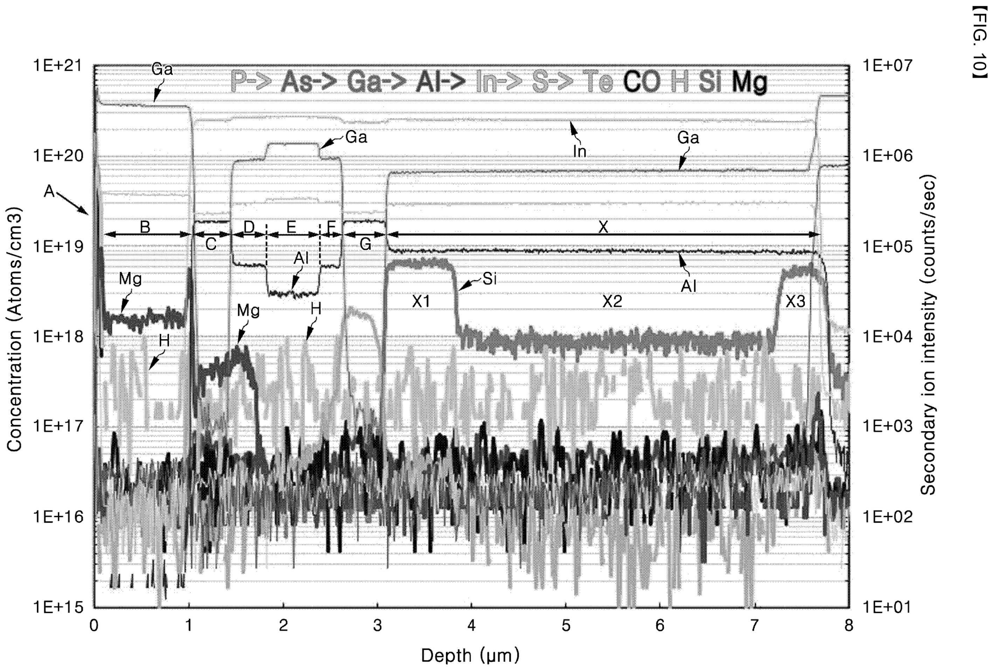

FIG. 10 is a graph depicting a composition of each layer of the light emitting device according to the first embodiment, which includes the first window layer 31, the first cladding layer 41, the first electron regulation layer 51, the active layer 60, the first hole regulation layer 52, the second cladding layer 42, the second window layer 32, and the contact layer 72. In FIG. 10, sections A to H are approximately shown for illustration and do not clearly depict boundaries of each layer.

Referring to FIG. 10, section A (where black (Mg) and yellow (H) curves indicate peaks) corresponds to the contact layer 72, section B corresponds to the second window layer 32, section C corresponds to the second cladding layer 42, section D corresponds to the first hole regulation layer 52, section E corresponds to the active layer 60, section F corresponds to the first electron regulation layer 51, and section G corresponds to the second hole regulation layer 52, and section H corresponds to the first window layer 31.

Hereinafter, the light emitting device according to the present invention will be described in detail with reference to FIG. 1 to FIG. 10.

The first light transmitting layer 20 transmits light emitted from the active layer 60 and may be formed of a light transmissive insulating material. As used herein, "light transmissive" means not only a transparent case that transmits all light, but also a translucent or partially transparent case that transmits only light having a predetermined wavelength or only some fractions of light having a predetermined wavelength. Hereinafter, this description will be applied in the same manner.

The first light transmitting layer 20 may be a substrate, and may be, for example, any one of a sapphire substrate, a silicon substrate, and a gallium nitride substrate.

The first window layer 31 serves to generate and supply electrons. Si or Te may be used as dopants for the first window layer 31.

The first window layer 31 of the light emitting device according to the first embodiment includes a first high-level doped layer. The first high-level doped layer is a layer that has a higher doping level than other portions of the first window layer 31 and is exposed in a process of etching the mesa M and is electrically connected to the first ohmic electrode 81. Hereinafter, a portion of the first window layer 31 having a lower doping level than the first high-level doped layer will be referred to as a "low-level doped layer". In FIG. 10, section H1 corresponds to the first high-level doped layer and section H2 corresponds to the low-level doped layer.

Since the first window layer 31 includes the first high-level doped layer, it is desirable that the first window layer have a greater thickness than a typical light emitting diode, and the thickness of the first window layer 31 may be 50% or more of the total thickness of the semiconductor layers of the light emitting device. Further, the thickness of the first window layer 31 may be 80% or more of the thickness of a portion below the active layer 60(by way of example, the portion below the active layer 60 includes the first electron regulation layer 51, the first cladding layer 41, the first window layer 31, the second light transmitting layer 25, and the first light transmitting layer 20 in FIG. 1. Hereinafter, this description will be applied in the same manner.). For example, the light emitting device may have an overall thickness of 4,500 nm to 7,600 nm, preferably 6,500 nm to 7,600 nm. The portion below the active layer 60 may have a thickness of 3000 nm to 5200 nm and the first window layer 31 may have a thickness of 3,000 nm to 5,000 nm.

Without the first high-level doped layer, the first window layer 31 forms poor ohmic contact with the first ohmic electrode 81. Since efficient ohmic contact can be formed between the first window layer 31 and the first ohmic electrode 81 when the first high-level doped layer is formed in the first window layer 31 and then contacts the first ohmic electrode 81, the mesa may be formed such that the first window layer 31 is exposed for electrical connection to the first ohmic electrode 81 in a direction from the second window layer 31 toward the first window layer 31. Accordingly, the first ohmic electrode 81 and the second ohmic electrode 82 may be arranged to face the same direction, thereby further facilitating electrical connection of the light emitting device to a circuit.

In addition, if the thickness of the first high-level doped layer is too thick or the doping level is too high, the supply amount of electrons becomes large, causing increasing in leakage of electrons, and if the thickness of the first high-level doped layer is too thin or the doping level is too low, ohmic contact with the first ohmic electrode 81 becomes poor. Thus, the inventor of the present invention optimized the doping level and thickness of the first high-level doped layer through a number of experiments.

The thickness of the first high-level doped layer may be about 3% to less than 30% of the thickness of the first window layer 31, about 5% to less than 30% of the thickness of the portion below the active layer 60, and about 30% or less, preferably about 6% to less than 20% of the overall thickness of the light emitting device. For example, when the light emitting device has a total thickness of 7,600 nm, the portion below the active layer 60 has a thickness of 5,200 nm, and the first window layer 31 has a thickness of 4,500 nm, the first high-level doped layer may have a thickness of 300 nm to 900 nm, preferably 400 nm to 600 nm.

In addition, the doping level of the first high-level doped layer may be less than or equal to 10 times, preferably 5 times to 10 times, the doping level of the low-level doped layer. By way of example, an average of the doping levels of the low-level doped layer may be about 1e17 to 3e18 (hereinafter, exponential notation is used) atoms/cm³, and the doping level of the first high-level doped layer may be 4e18 atoms/cm³ or more. With such a doping concentration relationship, the light emitting device can maintain stable electrical properties.

The figures presented above are examples of optimized figures in the current state of the art and it will be possible to optimize the present invention more advantageously as technology advances. For example, in the current state of the art, it can be difficult to form the first high-level doped layer to a thickness of less than 300 nm when the first window layer 31 has a thickness of 4,500. However, as technology advances, it may be possible to form the first high-level doped layer to a thickness of 300 nm or less, and the embodiments of the invention are not intended to exclude this possibility.

In the light emitting device according to the first embodiment, the first window layer 31 may include a second high-level doped layer having a higher doping level than the low-level doped layer on a lower surface(opposite the first high-level doped layer. Hereinafter, this description will be applied in the same manner) thereof.

The second high-level doped layer is a section that does not appear in a final product when the lower surface of the first window layer 31 is subjected to a texturing process, and increase in doping level of the second high-level doped layer allows not only efficient texturing of the first window layer 31, but also efficient interfacial bonding between the semiconductor layer and the first light transmitting layer 20 due to impurities when the first light transmitting layer 20 is bonded thereto after removal of the growth substrate. Further, when a bonding material is disposed between the semiconductor layer and the first light transmitting layer 20, effective interfacial bonding therebetween can be achieved.

The present invention includes both an embodiment in which the lower surface of the first window layer 31 is subjected to texturing and does not include the second high-level doped layer in the final stage, and an embodiment in which the first window layer 31 is not subjected to texturing and includes the second high-level doped layer in the final stage.

The doping level of the second high-level doped layer may be substantially similar to or slightly lower than the doping level of the first high-level doped layer, and section H3 of FIG. 10 corresponds to the second high-level doped layer.

The active layer 60 may be a multi-quantum well (MQW) layer formed by alternately stacking a quantum well (QW) layer and a quantum barrier (QB) layer several times, in which electrons and holes meet in the quantum well layer to generate light. The active layer 60 may have a thickness of 550 nm to 650 nm.

The quantum well layer and the quantum barrier layer have different energy bandgaps, in which the well layer is a layer having a composition of either AlInGaP or InGaP and may have a thickness in the range of 3 nm to 7 nm. The barrier layer may be formed of InₓGa_{y}Al_{z}P. Here, y+z may be set to satisfy a relation: x*0.8 ≤ y+z ≤ x*1.2. Alternatively, x+y+z=1. In addition, z may be set in the range of 0.15 ≤ z ≤ 0.4. Further, the quantum barrier layer may be formed by growing an InGaP layer as a quantum well layer, followed by sequentially growing an InAlGaP layer having an Al content of about 40% and a main InAlGaP layer having an Al content of about 50% to about 90% Al as capping layers.

The quantum well layer may be designed to have a thickness of about 5 nm and the quantum barrier layer may be designed to have a thickness of about 15 nm or less, and when the active layer 60 has a thickness of 550 nm to 650 nm, the number of pairs of the quantum well layer and the quantum barrier layer may be 10 or more, preferably about 20 to 40, more preferably about 40.

The second window layer 32 serves to generate and supply holes. The second window layer 32 may also be a GaP layer, and may contain Mg, C or a combination thereof as dopants. An average of the doping levels may be about 1e18 atoms/cm³. The second window layer 32 may have a thickness of 500 nm to 10,000 nm, preferably about 1,000 nm.

The growth temperature of the second window layer 32 may range from about 500 degrees Celsius to about 750 degrees Celsius and, in order to ensure quality of the second window layer 32, it is preferable to grow the second window layer 32 at a temperature of at least 20 degrees Celsius higher than the growth temperature of the active layer 60. For example, the growth temperature of the active layer 60 may be about 680 degrees Celsius and the growth temperature of the second window layer 32 may be about 700 degrees Celsius.

The second ohmic electrode 82 may be electrically connected to the second window layer 32 to form ohmic contact therewith and may be formed of a metallic material. Although the second ohmic electrode 82 may form ohmic contact with the second window layer 32 through direct contact therewith, a contact layer 72 may be formed on an upper surface of the second window layer 32 and may contact the second ohmic electrode 82 to form ohmic contact therewith. The second ohmic electrode 82 may be formed of a light reflective material or a light transmissive material. The light reflective material may be at least one of materials having reflective properties with respect to at least some components of light, such as Ge, Al, Cu, Ag, Au, Ni, Cr, Ti, Pt, Rd, Ru, W, Mo, TiW, and the like, and the light transmissive material may include at least one of materials having transmissive properties with respect to at least some components of light, such as ITO, ZnO, and the like.

The contact layer 72 may be disposed between the second ohmic electrode 82 and the second window layer 32 to efficiently form ohmic contact with the second ohmic electrode 82 and has a higher doping level than the second window layer 32. For example, when the second window layer 32 has an average doping level of about 1e18 atoms/cm³, the contact layer 72 may have an average doping level of about 1e19 atoms/cm³ or higher. The contact layer 72 may have a growth temperature of about 600 degrees Celsius or more and the contact layer 72 may be a GaP layer. Due to the high doping concentration of the dopants, defects can exist in the semiconductor layer and can cause light absorption to decrease optical efficiency upon increase in thickness. Therefore, preferably, the contact layer 72 has a thickness of less than 100 nm.

The first ohmic electrode 81 may be electrically connected to the first window layer 31 to form ohmic contact therewith and may be formed of a metallic material. The first ohmic electrode 81 may form ohmic contact with the high-level doped layer of the first window layer 31 through contact therewith. The first ohmic electrode 81 may be formed of a light reflective material or a light transmissive material. The light reflective material may be at least one of materials having reflective properties with respect to at least some components of light, such as Ge, Al, Cu, Ag, Au, Ni, Cr, Ti, Pt, Rd, Ru, W, Mo, TiW, and the like, and the light transmissive material may include at least one of materials having transmissive properties with respect to at least some components of light, such as ITO, ZnO, and the like.

The second light transmitting layer 25 is formed between the first light transmitting layer 20 and the first window layer 31 to transmit light emitted from the active layer 60 and may be formed of a light transmissive insulating material. The second light transmitting layer 25 may serve as a bonding layer that bonds the first window layer 31 to the first light transmitting layer 20, and may be formed of any material having light transmissive properties, such as silicone, polyimide, polypropylene, benzocyclobutene (BCB), silicon dioxide, and the like. The second light transmitting layer 25 may have a different index of refraction than the first window layer 31 and the second light transmitting layer 25, and may allow effective refraction of light at the interface having a different index of refraction, thereby improving light extraction.

The first cladding layer 41 is formed between the first window layer 31 and the active layer 60, acts as a barrier layer to prevent holes from crossing over into the first window layer 31, and has a relatively high energy bandgap for this function.

As dopants of the first cladding layer 41, dopants of a different element group than the dopants of the first window layer 31 or dopants having a larger atomic size than the dopants of the first window layer 31 may be used.

Si, B, P, As, Sb, or Te may be used as the dopants of the first cladding layer 41. Since Te has a larger atomic size than Si, using Te as a dopant has an advantage of obtaining a higher breakdown voltage (VR) and better luminous intensity properties and forming an n-type layer more reliably with only a smaller concentration than using Si as a dopant.

The first cladding layer 41 may be an n-InₓAl₍₁₋ₓ₎P layer where x is in the range of 0.4 ≤ x ≤ 0.6. The first cladding layer 41 may have a thickness of about 300 nm to about 450 nm and an average doping level of about 5e17 to 1e18 atoms/cm³.

The first electron regulation layer 51 is formed between the first window layer 31 and the active layer 60 to reduce the speed at which electrons reach the active layer 60, and when the light emitting device according to this embodiment includes both the first cladding layer 41 and the first electron regulation layer 51, the first electron regulation layer 51 is formed on the first cladding layer 41 (i.e., close to the active layer 60). The speed at which electrons reach the active layer 60 may be adjusted by adjusting the thickness of the first electron regulation layer 51 and the first electron regulation layer 51 may be an InₓGa_{y}Al_{z}P layer. Here, y and z may be set to satisfy a relation: x*0.8 ≤ y+z ≤ x*1.2. Alternatively, x+y+z=1. In addition, z may be set in the range of 0.15 ≤ z ≤ 0.4.

Due to this Al composition, light generated from the light emitting device can be prevented from being absorbed by the first electron regulation layer 51, thereby improving light extraction. The first electron regulation layer 51 may have a lower doping concentration than the first cladding layer 41 and may not include any doping material.

On the other hand, the first window layer 31 and the first electron regulation layer 51 may be formed of the same elements and the first cladding layer 41 may be formed of a composition free from one of the elements constituting the first window layer 31.

By way of example, the first window layer 31 may have a composition of four atoms coupled to each other, in which three atoms may be group III elements (B, Al, Ga, In, Tl, or Nh. Hereinafter, this description will be applied in the same manner) and the remaining atom may be an element having a standard atomic weight of 30 or more. The first cladding layer 41 may have a composition of three atoms coupled to each other, in which two atoms may be group III elements and the remaining atom may be an element having a standard atomic weight of 30 or more.

In addition, two group III elements of the first cladding layer 41 may be the largest atomic weight element and the smallest atomic weight element among the three group III elements of the first window layer 31. The element having a standard atomic weight of 30 or more in the first cladding layer 41 may be the same as the element having a standard atomic weight of 30 or more in the first window layer 31.

By way of example, the first window layer 31 and the first electron regulation layer 51 may be InₓGa_{y}Al_{z}P layers and the first cladding layer 41 may be an n-InₓAl₍₁₋ₓ₎P layer.

The first hole regulation layer 52 is formed between the active layer 60 and the second window layer 32 to reduce the speed at which holes reach the active layer 60, and the speed at which holes reach the active layer 60 may be adjusted by adjusting the thickness of the first hole regulation layer 52. The first hole regulation layer 52 may include the same group III and group V elements as the first electron regulation layer 51 and may be an InₓGa_{y}Al_{z}P layer. Here, y and z may be set to satisfy a relation: x*0.8 ≤ y+z ≤ x*1.2. Alternatively, x+y+z=1. In addition, z may be set in the range of 0.15 ≤ z ≤ 0.4. The first hole regulation layer 52 may have a lower doping concentration than the second cladding layer 42 and may not include any doping material.

The second cladding layer 42 is formed between the active layer 60 and the second window layer 32 to act as a barrier layer that prevents electrons from crossing over into the second window layer 32, and has a relatively high energy bandgap for this function.

The second cladding layer 42 may have a thickness of 500 nm or less, preferably from about 300 nm to about 500 nm. The second cladding layer 42 may have an average doping level of about 8e17 to 1e18 atoms/cm³ and may use Mg, C or both Mg and C as dopants. In addition, the second cladding layer 42 may be a p-InₓAl₍₁₋ₓ₎P layer, where x is in the range of 0.4 ≤ x ≤ 0.6. The second cladding layer 42 may be formed of two group III elements and may have a greater energy bandgap than layers formed on upper and lower surfaces of the second cladding layer 42. Alternatively, the second cladding layer 42 may have the largest energy bandgap among the semiconductor layers constituting the light emitting device.

When the light emitting device according to this embodiment includes both the first hole regulation layer 52 and the second cladding layer 42, the first hole regulation layer 52 is formed under the second cladding layer 42 (i.e., close to the active layer 60). Further, in order to protect the active layer 60 from interdiffusion during a doping process of the second cladding layer 42, it is desirable that the first hole regulation layer 52 be formed thicker than the first electron regulation layer 51. By way of example, when the first electron regulation layer 51 has a thickness of about 150 nm to about 350 nm, the first hole regulation layer 52 may have a thickness of about 300 nm to about 500 nm. Alternatively, the thickness of the first hole regulation layer 52 may be 1 to 2 times the thickness of the first electron regulation layer 51. With this structure, it is possible to achieve balance between the migration speeds of electrons and holes.

The light emitting device according to this embodiment may further include a light guide layer between the second window layer 32 and the active layer 60 and/or between the active layer 60 and the first window layer 32.

For the light emitting device including the second cladding layer 42, the first hole regulation layer 52, the first electron regulation layer 51, and the first cladding layer 41, the light guide layer may be formed between the second window layer 32 and the second cladding layer 42 and/or between the first cladding layer 41 and the first window layer 31.

The light guide layer serves to increase luminous efficacy of the light emitting device by increasing reflectivity with respect to light emitted from the active layer 60 and may be an InₐAl₍₁₋ₐ₎P layer or an InₓGa_{y}Al_{z}P layer. Here, a may be set in the range of 0.4 ≤ a ≤ 0.6 and y+z may be set to satisfy a relation: x*0.8 ≤ y+z ≤ x*1.2. Alternatively, x+y+z=1. In addition, z may be set in the range of 0.15 ≤ z ≤ 0.4. Two layers may be a form stacked of layers with different band gaps, or a form repeatedly stacked multiple pairs formed by layers with different band gaps. The n-InₐAl₍₁₋ₐ₎P layer may be formed to have an index of refraction of 2.9 to 3.0 and the InₓGa_{y}Al_{z}P layer may be formed to have an index of refraction of 3.05 to 3.2. With the structure in which two layers having a difference of 0.05 to 0.3 in index of refraction therebetween are placed inside the semiconductor layer, the light guide layer can guide light generated from the active layer to be extracted in a desired direction, thereby improving light extraction efficiency.

The light guide layer may be disposed between the active layer 60 and the first window layer 31. Thus, the light guide layer can change a traveling path of light generated from the active layer 60 and directed towards the first window layer 31 such that the path of light can be directed from the first window layer 31 towards the second window layer 32, thereby improving light extraction. Here, at least one layer of the light guide layer may be doped with n-type dopants such that the light guide layer has a structure composed of two layers having different doping concentrations. Alternatively, both layers of the light guide layer may be doped with n-type dopants such that the light guide layer has a structure composed of two layers having different doping concentrations. Alternatively, both layers of the light guide layer may be doped with n-type dopants such that the light guide layer has a structure composed of two layers having the same doping concentration. With the n-type doped layer, the light guide layer can guide light while facilitating migration of electrons.

In another embodiment, the light guide layer may be disposed between the active layer 60 and the second window layer 32. The light guide layer can change the path of light generated in the active layer and directed towards the second window layer 32 such that the path of light can be directed from the second window layer 32 towards the first window layer 31, thereby improving light extraction. Here, at least one layer of the light guide layer may be doped with p-type dopants such that the light guide layer has a structure composed of two layers having different doping concentrations. Alternatively, both layers of the light guide layer may be doped with p-type dopants such that the light guide layer has a structure composed of two layers having different doping concentrations. Alternatively, both layers of the light guide layer may be doped with p-type dopants such that the light guide layer has a structure composed of two layers having the same doping concentration. With the p-type doped layer, the light guide layer can guide light while facilitating migration of holes.

The insulating layer 90 covers most of the exposed surface of the light emitting device and may include SiO₂. The first ohmic electrode 81 may be electrically connected to the first bump 101 through an opening 95 formed in the insulating layer 90 on an upper surface of the first ohmic electrode 81 and the second ohmic electrode 82 may be electrically connected to the second bump 102 through the opening 95 formed in the insulating layer 90 on an upper surface of the second ohmic electrode 82. The first bump 101 and the second bump 102 may be formed of a conductive material and may be composed of materials, such as Ge, Al, Cu, Ag, Au, Ni, Cr, Ti, Pt, Rd, Ru, W, Mo, TiW, and the like.

An edge of the second bump 102, which is formed on the upper surface of the second ohmic electrode 82, may be placed inside an edge of the insulating layer 90. Further, the second bump 102 may have the same width as the second ohmic electrode 82 or may have a narrower width than the second ohmic electrode 82.

An edge of the first bump 101, which is formed on the upper surface of the first ohmic electrode 81, may extend beyond the edge of the insulating layer 90 to an upper surface of the first window layer 31. In addition, the first bump 101 may have a greater width than the first ohmic electrode 81.

In this embodiment, the first window layer 31, the first ohmic electrode 81 and the first cladding layer 41 are of first conductivity types, and the second window layer 32, the second ohmic electrode 82 and the contact layer 72 are of second conductivity types. The first conductivity type and the second conductivity type are of opposite polarity. Thus, when the first conductivity type is n-type, the second conductivity type is p-type, and when the first conductivity type is p-type, the second conductivity type is n-type.

Although FIG. 9 shows that side surfaces of the mesa M are formed vertically, at least some of the side surfaces of the mesa M of the light emitting device according to this embodiment may be slanted.

As compared with the light emitting modules according to the second to fourth embodiments described below, the light emitting module according to this embodiment is characterized in that a plurality of light emitting devices is mounted substantially over most of the area of the light emitting module rather than being mounted in some area of the light emitting module. Preferably, the area of the light emitting device (preferably the first window layer) is 70% or more of the area of the substrate of the light emitting module or in the range of 0.7 to 1 times the area of the substrate thereof. Here, the substrate may be a circuit board, an insulating substrate, a growth substrate, or the like.

As such, the light emitting module according to this embodiment is provided with the light emitting device formed over the entire plane thereof and thus can be advantageously used when there is a need for a single color with high brightness, for example, in a display device or a vehicular brake lamp requiring a single-color high brightness light source in the red series.

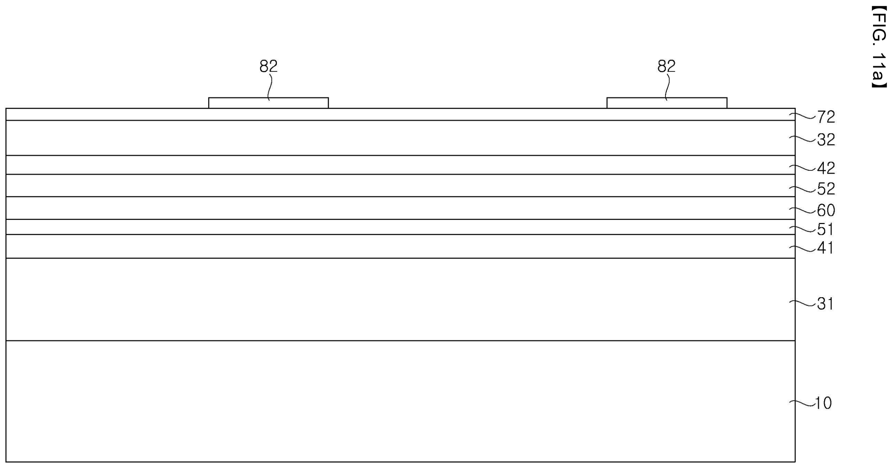

FIGS. 11a to 11m are cross-sectional views sequentially illustrating a method of manufacturing the light emitting device according to the first embodiment of the present invention.

Referring to FIG. 11a, the method of manufacturing the light emitting device according to this embodiment includes a "p-ohmic process" in which a second ohmic electrode 82 is formed on a second window layer 32 (or on a contact layer 72, when including the contact layer 72) after growth of each layer on a growth substrate 10. The growth substrate 10 may be a gallium arsenide (GaAs) substrate.

A buffer layer (not shown) may be formed between the growth substrate 10 and a first window layer 31. The buffer layer may be formed to a thickness of about 300 nm and may be a gallium arsenide (GaAs) layer.

An etch-stop layer (ESL) may be formed between the growth substrate 10 and the first window layer 31 (or between the buffer layer and the first window layer 31 when including the buffer layer) to prevent other thin layers from being damaged by an etchant solution. However, the etch stop layer may be omitted, as needed.

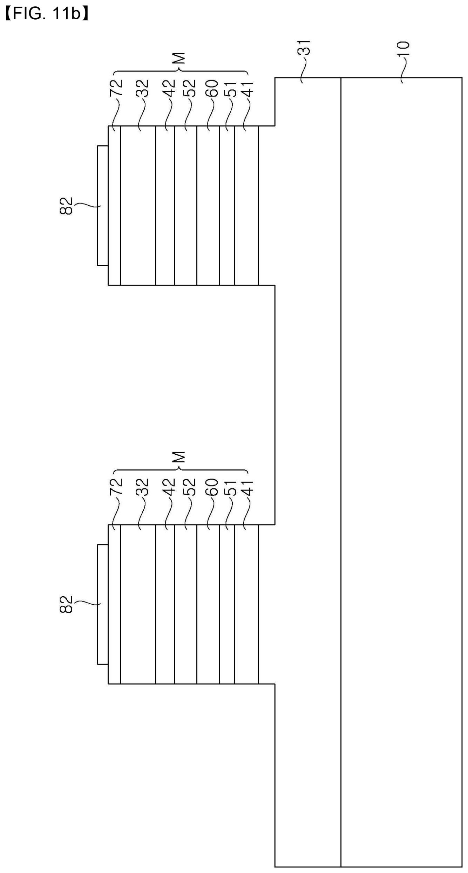

Referring to FIG. 11b, the method of manufacturing the light emitting device according to this embodiment includes a "mesa process" in which the grown layers are partially etched to form a mesa M. In the "mesa process," the first high-level doped layer of the first window layer 31 is exposed. Although FIG. 11b shows that the side surfaces of the mesa M are formed vertically, at least some of the side surfaces of the mesa M may be formed to be slanted. Hereinafter, this description will be applied in the same manner.

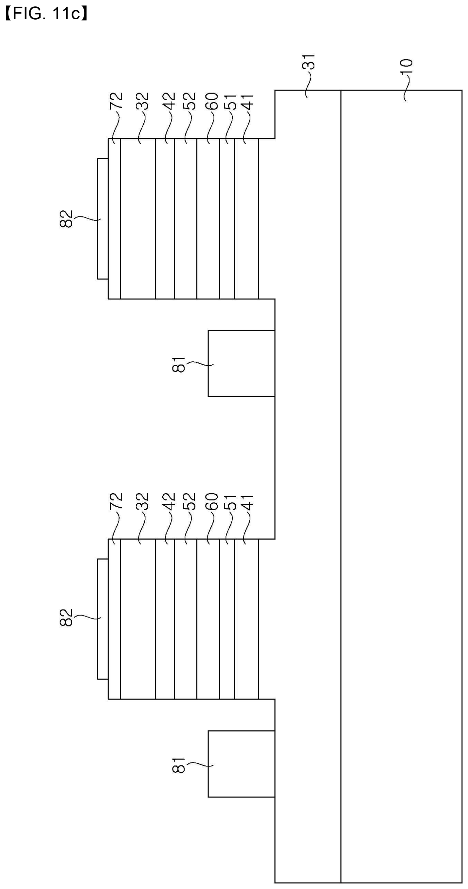

Referring to FIG. 11c, the method of manufacturing the light emitting device according to this embodiment includes an "n-ohmic process" to form a first ohmic electrode 81 contacting the first high-level doped layer on the first window layer 31. The first ohmic electrode 81 may be formed such that the upper surface of the first ohmic electrode 81 is flush with the upper surface of the second ohmic electrode 82.

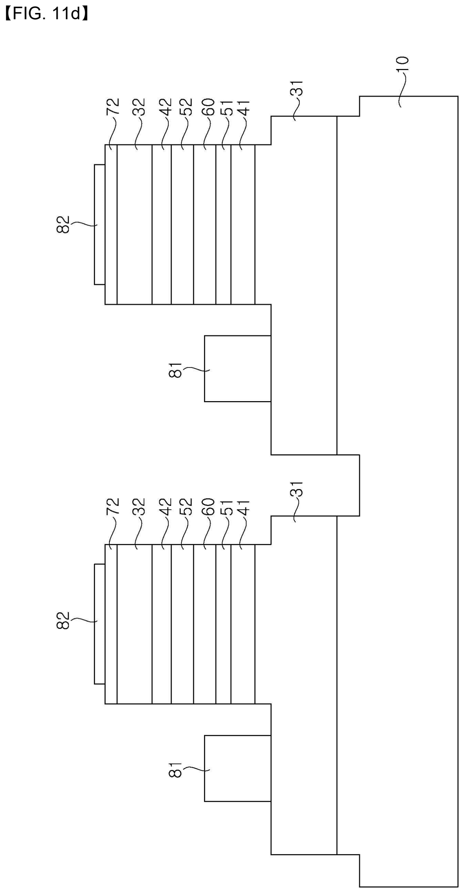

Referring to FIG. 11d, the method of manufacturing the light emitting device according to this embodiment includes an "isolation (ISO) process" to divide the layers integrally grown on the growth substrate 10 into individual light emitting devices.

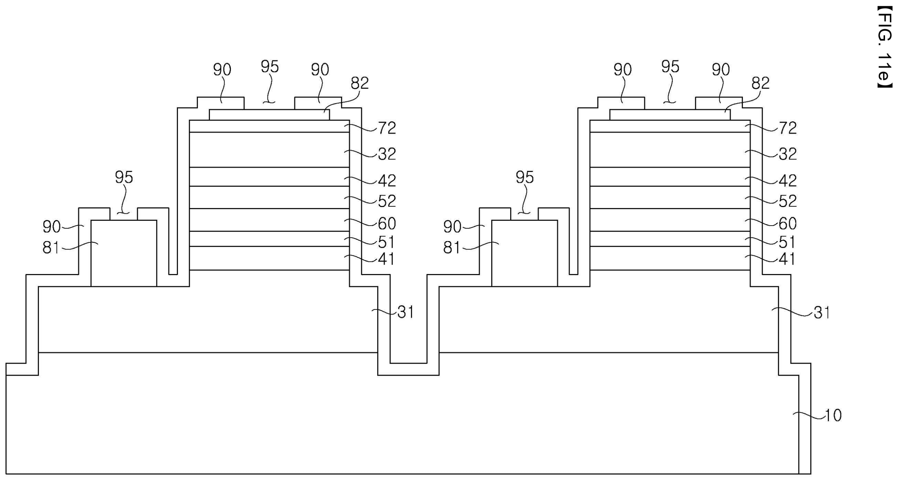

Referring to FIG. 11e, the method of manufacturing the light emitting device according to this embodiment includes a "passivation and via process" to form an insulating layer 90 on an exposed surface of the light emitting device and to form openings 95 in the insulating layer 90. The insulating layer 90 covers most of the upper and side surfaces of the light emitting device and the openings 95 may be formed in the insulating layer 90 on the upper surface of the first ohmic electrode 81 and in the insulating layer 90 on the upper surface of the second ohmic electrode 82, respectively.

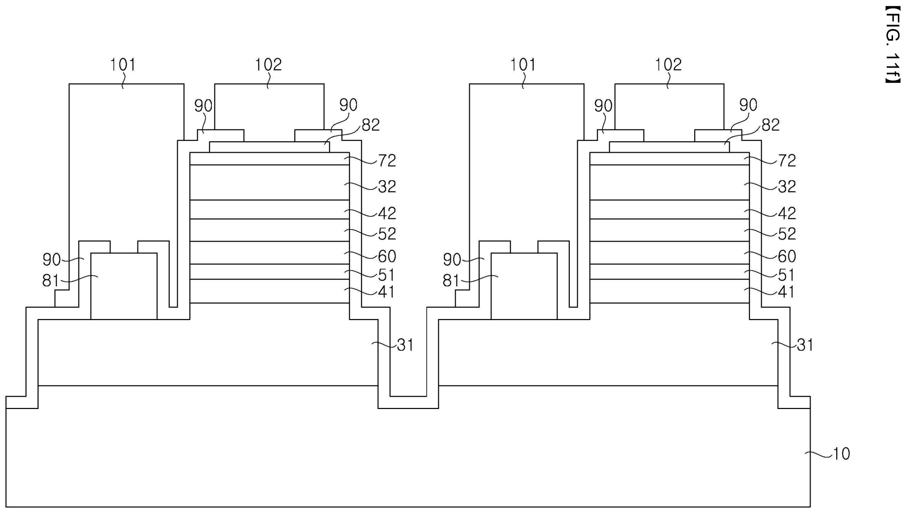

Referring to FIG. 11f, the method of manufacturing the light emitting device according to this embodiment includes a "bump process" in which a first bump 101 and a second bump 102 are formed on an upper surface of the insulating layer 90. The edge of the second bump 102 formed on the upper surface of the second ohmic electrode 82 may be formed within the edge of the insulating layer 90, and the edge of the first bump 101 formed on the upper surface of the first ohmic electrode 81 may extend beyond the edge of the insulating layer 90 to the upper surface of the first window layer 31.

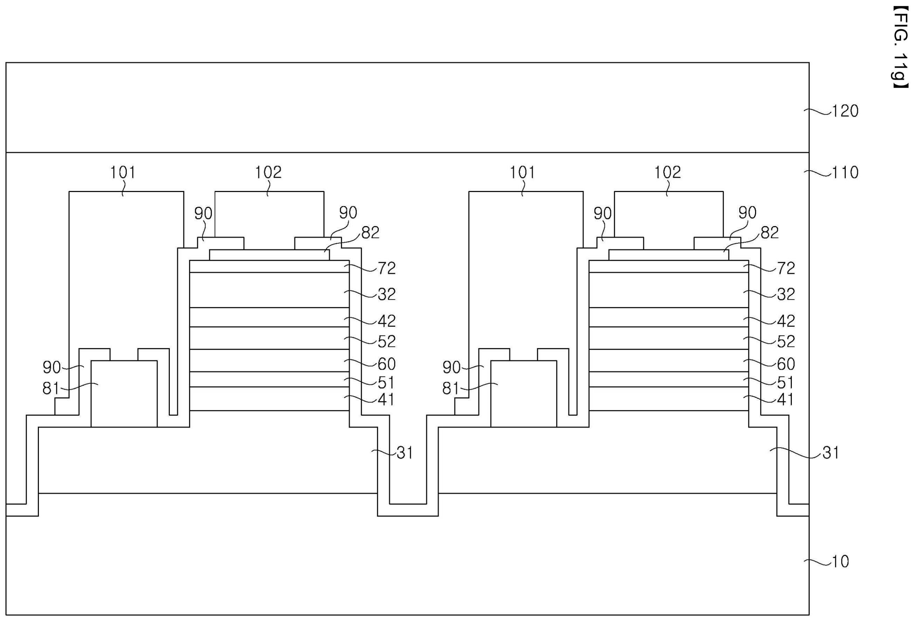

Referring to FIG. 11g, the method of manufacturing the light emitting device according to this embodiment includes a "temporary bonding process" in which a temporary plate 120 is bonded to exposed upper surfaces (i.e., opposite the growth substrate 10) of the insulating layer 90, the first bump 101, and the second bump 102.

The temporary substrate 120 serves to support the light emitting device during a process of removing the growth substrate 10 described below and may be any one of a sapphire substrate, a silicon substrate, and a gallium nitride substrate.

The temporary plate 120 may be bonded thereto by a bonding layer 110. That is, the bonding layer 110 may be formed on the exposed upper surfaces of the insulating layer 90, the first bump 101 and the second bump 102, and the temporary plate 120 may be formed on an upper surface of the bonding layer 110.

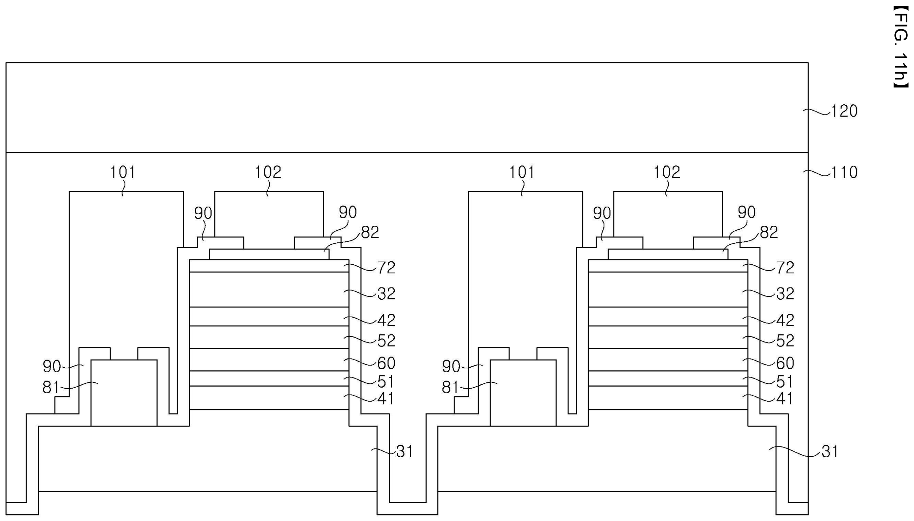

Referring to FIG. 11h, the method of manufacturing the light emitting device according to this embodiment includes a "growth substrate removal process" in which the growth substrate 10 is removed using techniques, such as mechanical polishing, laser lift-off, chemical lift-off, and the like.

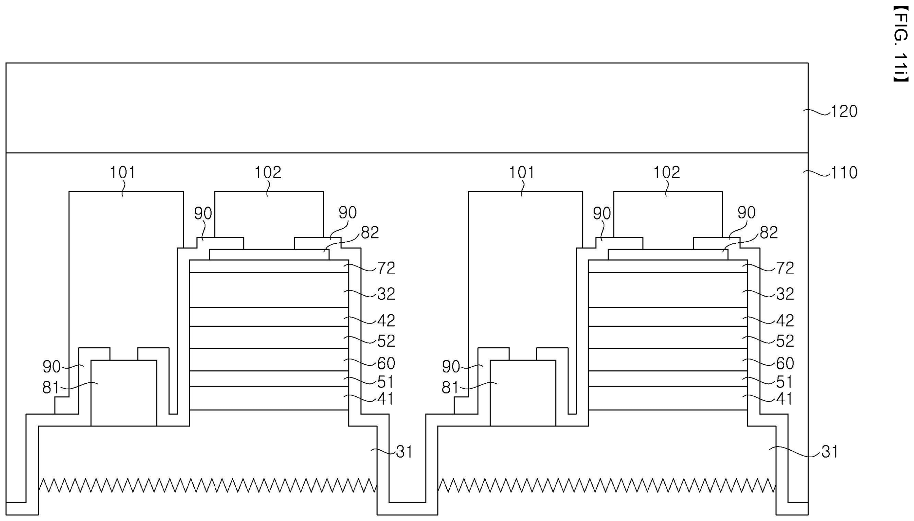

Referring to FIG. 11i, a method of manufacturing a light emitting device according to this embodiment may include a "texturing process" in which a lower surface of the first window layer 31 exposed after removal of the growth substrate 10 is subjected to texturing.

Unlike difficulty of texturing in a light emitting device using a growth substrate having light absorption properties, such as gallium arsenide (GaAs) and the like, the present invention has an advantage of allowing surface texturing of a light exit surface, thereby improving luminous efficacy.

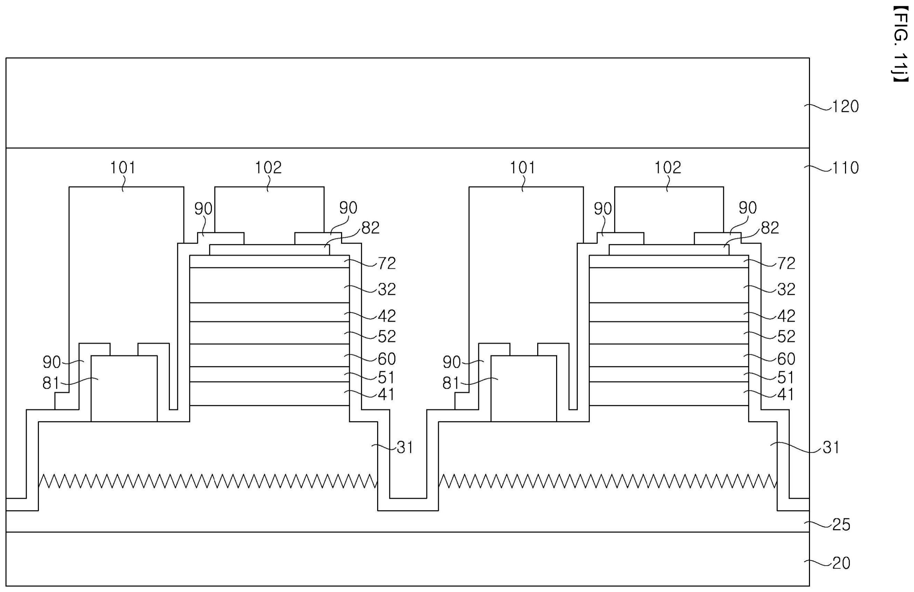

Referring to FIG. 11j, the method of manufacturing the light emitting device according to this embodiment includes a "permanent bonding process" in which the first light transmitting layer 20 is bonded to a lower surface of the first window layer 31 (that is, an opposite side of the temporary plate 120).

A second light transmitting layer 25 may be formed between the first light transmitting layer 20 and the first window layer 31. The second light transmitting layer 25 may serve as a bonding layer to join the first window layer 31 and the first light transmitting layer 20, and may be formed of any material having light transmissive properties, such as silicone, polyimide, polypropylene, benzocyclobutene (BCB), silicon dioxide, and the like. The second light transmitting layer 25 may have a different index of refraction than the first window layer 31 and the second light transmitting layer 25, and may allow effective refraction of light at the interface having a different index of refraction, thereby improving light extraction.

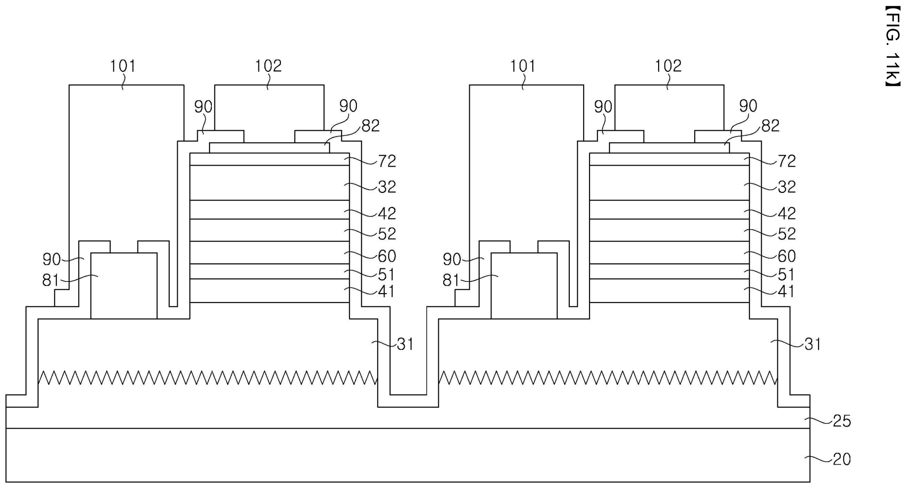

Referring to FIG. 11k, the method of manufacturing the light emitting device according to this embodiment includes a "temporary bonding removal process" in which the temporary substrate 120 is removed. The temporary substrate 120 may be removed by chemically dissolving the bonding layer 110.

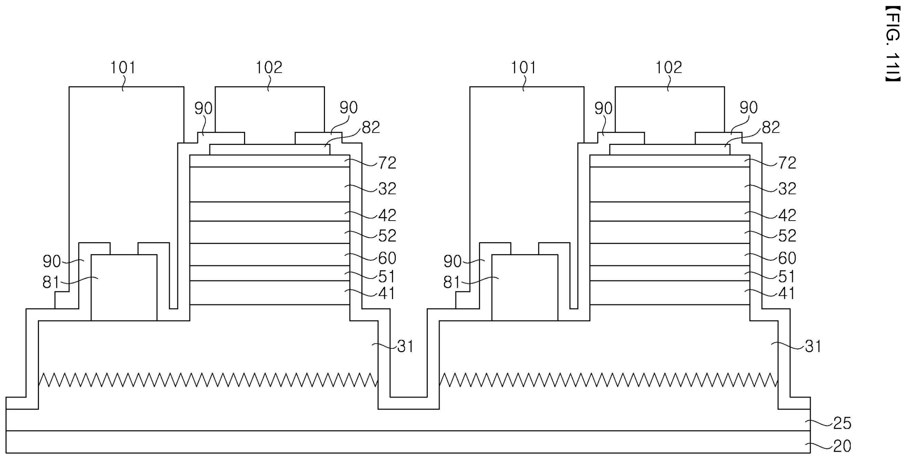

Referring to FIG. 11l, the method of manufacturing the light emitting device according to this embodiment includes a "thinning process" to reduce the thickness of the first light transmitting layer 20 as needed.

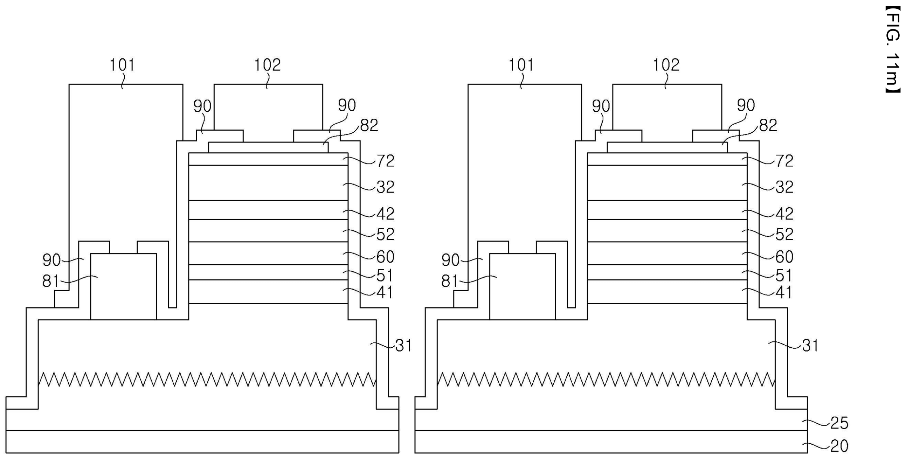

Referring to FIG. 11m, the method of manufacturing the light emitting device according to this embodiment includes a "breaking process" in which the formed layers are diced into chips. The breaking process may be accomplished by a stealth dicing (SD) method. Although not shown in the drawings, the first light transmitting layer 20 may include lateral irregularities around an outer surface thereof to improve light diffusion efficiency. An outer boundary of the first light transmitting layer 20 may be disposed outside an outer boundary of the light emitting device. Thus, since the first light transmitting layer 20 has a larger area than the light emitting device and supports the light emitting device, the light emitting device can be protected from external force applied thereto. Furthermore, since a transverse width w2 of the first light transmitting layer 20 is greater than a transverse width w1 of the light emitting device, it is possible to ensure that the light emitting device can effectively emit light to the outside through the first light transmitting layer 20 even when the light emitting device has a wide beam angle. The second light transmitting layer 25 may include regions with different thicknesses. A thickness t2 of a region of the second light transmitting layer 25 disposed outside the outer boundary of the light emitting device and not overlapping the light emitting device may be smaller than a thickness t1 of a region of the second light transmitting layer 25 overlapping the light emitting device. Accordingly, the insulating layer 90 covering the light emitting device may extend to the region having the thickness t2. Since the second light transmitting layer 25 includes the regions with different thicknesses, the surface area of the second light transmitting layer 25 can be enlarged, thereby improving lifespan of the light emitting device by lengthening a path of moisture penetrating into the light emitting device. An outer boundary of the first window layer 31 may include a slanted side surface.

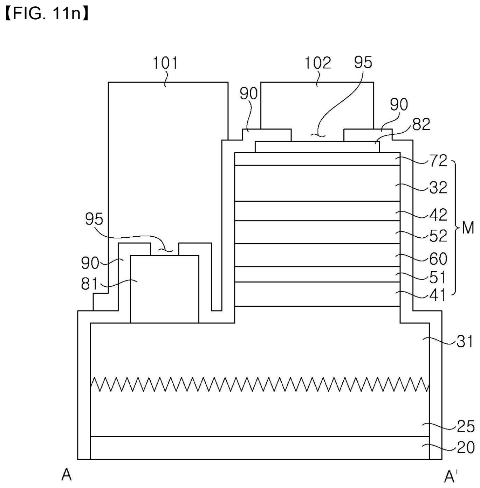

FIG. 11n is a schematic cross-sectional view of a light emitting module according to another embodiment of the present invention. Referring to FIG. 11n, the boundaries of the first window layer 31 and the second light transmitting layer 25 may be formed parallel to each other and the boundary of the second light transmitting layer 25 may be formed parallel to the boundary of the first light transmitting layer 20.

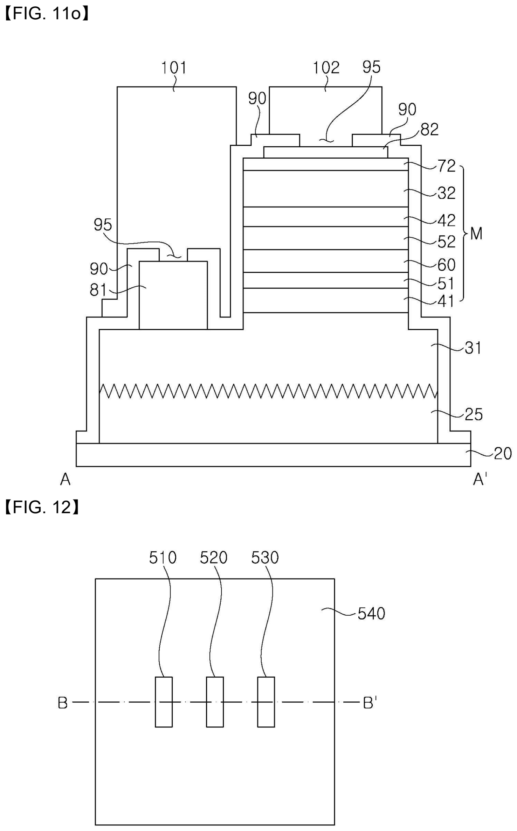

FIG. 11o is a schematic cross-sectional view of a light emitting module according to a further embodiment of the present invention. Referring to FIG. 11o, an outer periphery of the first light transmitting layer 20 may be exposed from the second light transmitting layer 25. Further, an exposed surface of the first light transmitting layer 20 may be covered with an insulating material, and the insulating material covering the exposed surface of the first light transmitting layer 20 may be formed of a different material than the second light transmitting layer 25. The insulating material may be the same as the insulating layer 90 covering the light emitting device, or may be a different material than the second light transmitting layer 25. The insulating material may also cover the side surface of the second light transmitting layer 25.

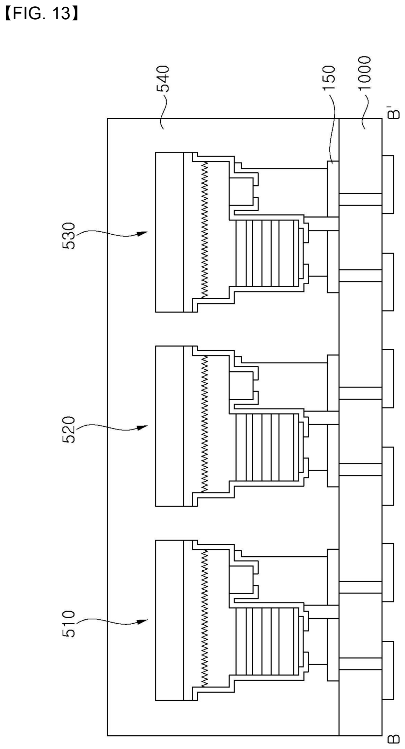

FIG. 12 is a schematic plan view of light emitting modules according to second to fourth embodiments of the present invention and FIG. 13 is a schematic cross-sectional view of the light emitting modules according to the second to fourth embodiments taken along B-B' in FIG. 12.

Referring to FIG. 12 and FIG. 13, unlike the light emitting module according to the first embodiment in which the light emitting devices are formed over the entire plane thereof, the light emitting modules according to the second to fourth embodiments includes a plurality of light emitting devices 510, 520, 530 formed in some region on the first light transmitting layer 20, for example, three light emitting devices 510, 520, 530 mounted side by side.

According to the second to fourth embodiments, each of the light emitting devices 510, 520, 530 may have the same configuration as the light emitting device according to the first embodiment. The light emitting module according to the present invention has an advantage of convenient circuit construction through the structure in which even the light emitting device of red-series has the same mesa (M) direction as the light emitting devices emitting other colors. Each of the light emitting devices 510, 520, 530 is electrically connected to the electrode pad 150 such that light having a predetermined wavelength can be emitted from the active layer of each of the light emitting devices 510, 520, 530.

In one embodiment, a difference in peak wavelength of light emitted from the light emitting devices 510, 520, 530 may be 5 nm or less and the materials constituting the active layers of the light emitting devices 510, 520, 530 may be composed of the same elements. Alternatively, the materials for the light emitting devices 510, 520, 530 may be composed of the same group V elements. Accordingly, a plurality of light emitting devices with similar electrical and optical properties may be grouped into a single unit and thus can be more easily arranged in a module. Semiconductor layers constituting each of the light emitting devices 510, 520, 530 may include a first type semiconductor layer and a second type semiconductor layer, and a first type dopant material of each of the light emitting devices 510, 520, 530 may include the same material or a second type dopant material of each of the light emitting devices 510, 520, 530 may include the same material. The plurality of first type semiconductor layers may be disposed in the same direction relative to the active layer. In addition, the plurality of first type semiconductor layers may be spaced apart from each other and a thickness difference between the first type semiconductor layers may be within 30%. Alternatively, the plurality of second type semiconductor layers may be disposed in the same direction relative to the active layer. In addition, the plurality of second type semiconductor layers may be spaced apart from each other and a thickness difference between the second type semiconductor layers may be within 30%. Accordingly, the light emitting module can reduce deviation in luminous intensity due to the thickness deviation of the semiconductor layers. Alternatively, the light emitting devices 510, 520, 530 may be arranged to allow electrons to be supplied to the active layers in the same direction. Alternatively, the light emitting devices 510, 520, 530 may be arranged to allow holes to be supplied to the active layers in the same direction. Accordingly, it is possible to prevent electric or magnetic field interference between the light emitting devices spaced apart from each other.

In one embodiment, a difference between at least two peak wavelengths of a plurality of light components emitted from the light emitting devices 510, 520, 530 may be 10 nm or more. In addition, at least one of the plurality of light emitting devices 510, 520, 530 may include a different kind of group V element constituting the semiconductor layer thereof. Alternatively, at least one of the plurality of light emitting devices 510, 520, 530 may include a material composed of a group V element constituting the semiconductor layer and having a standard atomic weight of 30 or more. Alternatively, at least one of the plurality of light emitting devices 510, 520, 530 may be formed of a material with different sizes of group V elements constituting the semiconductor layer. The semiconductor layers constituting each of the light emitting devices 510, 520, 530 may include first type semiconductor layers and second type semiconductor layers, in which the plurality of first type semiconductor layers may be spaced apart from each other and may be arranged in the same direction relative to the active layer. Alternatively, the plurality of second type semiconductor layers may be spaced apart from each other and may be arranged in the same direction relative to the active layer. Accordingly, the directions of polarities of the light emitting devices constituting a single light emitting module or a single pixel are arranged in the same direction, whereby a height deviation from the active layers of the light emitting devices 510, 520, 530 to a light exit surface of a molding portion 540 can be minimized.

In one embodiment, the light emitting devices 510, 520, 530 may have different emission peak wavelengths. Alternatively, each of the light emitting devices 510, 520, 530 may further include a substrate supporting the corresponding light emitting device 510, 520 or 530 and formed of the same material. In other words, at least one of the light emitting devices 510, 520, 530 may contain a different kind of group V element or may emit light having a different peak wavelength than the other light emitting devices, and the substrates supporting the light emitting devices 510, 520, 530 may be formed of the same material, thereby reducing deviation in visual sensitivity depending upon the kind of substrate even when light is emitted through the substrate.

The first light transmitting layer 20 may be formed on the upper surface thereof with the molding portion 540 to cover the light emitting devices 510, 520, 530. The first light transmitting layer 20 may be a substrate, for example, any one of a sapphire substrate, a silicon substrate, and a gallium nitride substrate. Description of the same configuration as the first embodiment will be omitted hereinafter.

The light emitting module according to the second embodiment of the present invention includes a first light emitting device 510 of red-series, a second light emitting device 520 of green-series, and a third light emitting device 530 of blue-series; the light emitting module according to the third embodiment of the present invention includes a first light emitting device 510 of red-series, a second light emitting device 520 of yellow-series, and a third light emitting device 530 of cyan-series; and the light emitting module according to the fourth embodiment of the present invention includes first to third light emitting devices 510, 520, 530 of red-series.

The light emitting modules according to the first to fourth embodiments of the present invention may have a luminance of 4 cd to 60 cd, and may be particularly suitable for use in a vehicular rear lamp.

Although the light emitting modules according to the second to fourth embodiments are illustrated as having the same structure as the light emitting module according to the first embodiment herein, it should be understood that the present invention is not limited thereto.

In addition, although the light emitting modules according to the second to fourth embodiments are illustrated as having the same structure herein, it should be understood that the present invention is not limited thereto and the light emitting modules according to the second to fourth embodiments may include at least one light emitting device having a different structure than the other light emitting devices, as needed.

Further, the light emitting modules according to the first to fourth embodiments of the present invention may be formed in the same size and may include the same electrode pads, as shown in FIG. 8. As such, since the light emitting modules according to the first to fourth embodiments are formed in the same size and use the same electrode pads, a user can freely select and arrange the light emitting modules according to the first to fourth embodiments, as needed.

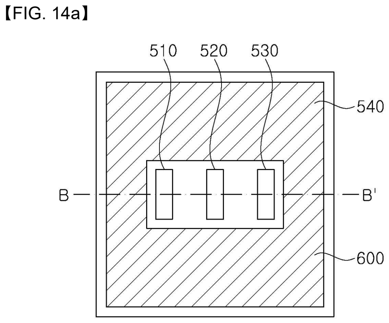

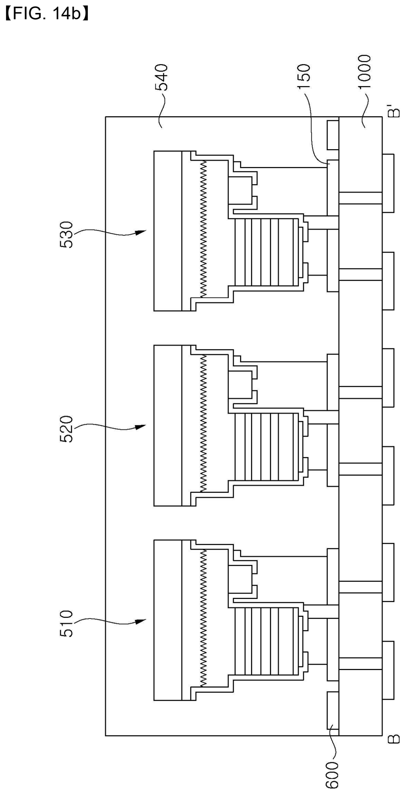

FIG. 14a is a schematic plan view of a light emitting module according to yet another embodiment of the present invention and FIG. 14b is a schematic cross-sectional view of the light emitting module taken along B-B' in FIG. 14a.

Referring to FIG. 14a and FIG. 14b, a light reflective layer 600 may be further disposed on an upper surface of a module substrate 1000 and may have a reflectivity of 80% or more with respect to light emitted from the light emitting devices 510, 520, 530.

Referring to FIG. 14a, in a top plan view, an opening is formed inside the light reflective layer 600 and the light emitting devices 510, 520, 530 are disposed in the opening such that the light reflective layer 600 surrounds the light emitting devices 510, 520, 530.

Referring to FIG. 14b, in a side view, the light reflective layer 600 extends outwards along an upper surface of the module substrate 1000 from the opening inside the light reflective layer in which the light emitting devices 510, 520, 530 are disposed. The thickness of the light reflective layer 600 may be similar to or the same as the thickness of the electrode pad 150, but is not limited thereto.

Further, a side surface of the light reflective layer 600 may be covered by the molding portion 540. This structure can further flatten the surface of the light reflective layer 600 by preventing the light reflective layer 600 from delaminating from the module substrate 1000, thereby improving a light reflective effect.

Although not shown in the drawings, the light reflective layer 600 may extend into a region between the light emitting devices 510, 520, 530. The light reflective layer 600 may include a metallic material or an insulating material. For example, the metallic material may be one of materials, such as Al, Au, Au, Ni, Ti, and the like, and the insulating material may be a material, such as silicone, polyimide, and the like.

Although not shown in the drawings, the light emitting devices described herein may be independently driven or controlled and the light emitting module may be provided therein with an IC circuit or IC driver. The IC circuit or IC driver may be electrically connected to the plurality of light emitting devices and may be covered together with the plurality of light emitting devices by the molding layer. Therefore, the IC circuit or IC driver can be handled together with the plurality of light emitting devices and thus can be easily applied to a product. A height from an upper surface of the IC circuit or IC driver to the light exit surface of the molding layer may be different from a height from the upper surface of the light emitting devices to the light exit surface of the molding layer. However, the molding layer may compensate for this height difference such that the light exit surface is placed at the same location.

A system according to the present invention includes a plurality of light emitting modules disposed in each section, wherein the light emitting module in each section is at least one of first to fourth light emitting modules.

The first light emitting module includes light emitting devices mounted over the entire plane thereof (corresponding to the first embodiment); the second light emitting module includes a first light emitting device of red-series, a second light emitting device of green-series, and a third light emitting device of blue-series (corresponding to the second embodiment); the third light emitting module includes a first light emitting device of red-series, a second light emitting device of yellow-series, and a third light emitting device of cyan-series (corresponding to the third embodiment); and the fourth light emitting module includes first to third light emitting devices of red-series (corresponding to the fourth embodiment).

In the system according to the present invention, a user can freely select and arrange one or more light emitting modules according to the first to fourth embodiments in each section, as needed.

By way of example, the light emitting module of the first embodiment may be disposed in a first section, the light emitting module of the second embodiment may be disposed in a second section, and the light emitting module of the third embodiment may be disposed in a third section. Alternatively, two or more light emitting modules according to the first to fourth embodiments may be arranged together, for example, arrangement of the light emitting modules according to the first and third embodiments in the first section, arrangement of the light emitting modules according to the second and fourth embodiments in the second section, and the like.

For example, the system according to the present invention may employ the light emitting module of the first embodiment for use in high brightness brakes, the light emitting module of the second embodiment for implementation of all colors, the light emitting module of the third embodiment for products specialized for electric vehicles, and the light emitting module of the fourth embodiment for precise and fine adjustment of red luminance.

The system according to the present invention may be applied to vehicular displays, particularly tail lights of automobiles, charging signals in electric vehicles, and the like.

The system according to the present invention may be configured to implement a string of characters (English, figures, Korean, and the like). For example, the first section may implement a first character, the second section may implement a second character, the third section may implement a third character, and the fourth section may implement a fourth character.

The system according to the present invention may be configured to be implemented via a subscription service. By way of example, the system may be designed to allow a particular color, a particular character, a particular shape, and the like to be implemented on a display when a user subscribes to a service for the particular color, the particular character, the particular shape, and the like.

Although not shown in the drawings, in other embodiments, the light emitting device may be applied to a plant lighting module designed to assist in growth of plants. The plant lighting module includes a circuit board and a plurality of light emitting devices 510, 520, 530 mounted on the circuit board. The plurality of light emitting devices may include any one of the light emitting devices according to the above embodiments.

The plurality of light emitting devices included in the light emitting module according to the present invention may be individually controlled.

Although some exemplary embodiments have been described herein with reference to the accompanying drawings, it should be understood that various modifications and changes can be made by those skilled in the art or by a person having ordinary knowledge in the art without departing from the spirit and scope of the invention, as defined by the claims and equivalents thereto.

Therefore, the scope of the invention should be defined by the appended claims and equivalents thereto instead of being limited to the detailed description of the invention.

## Claims

1. A light emitting module comprising a light emitting device, and the light emitting device comprising:
a substrate;
a first window layer supplying electrons;
a second window layer supplying holes;
an active layer disposed between the first window layer and the second window layer;
a first ohmic electrode electrically connected to the first window layer; and
a second ohmic electrode electrically connected to the second window layer,
wherein the first window layer comprises a first high-level doped layer having a higher doping level than other portions thereof, and
wherein the first ohmic electrode is electrically connected to the first high-level doped layer.

2. The light emitting module according to claim 1, wherein the doping level of the first high-level doped layer electrically connected to the first ohmic electrode is 4e18 atoms/cm³ or more.

3. The light emitting module according to claim 1, further comprising:
a contact layer disposed between the second window layer and the second ohmic electrode,
wherein the second ohmic electrode is contacted to the contact layer.

4. The light emitting module according to claim 1, further comprising:
a first cladding layer disposed between the first window layer and the active layer to prevent the holes from crossing over into the first window layer.

5. The light emitting module according to claim 1, further comprising at least one of:
a first electron regulation layer disposed between the first window layer and the active layer to regulate a speed at which the electrons reach the active layer; or
a first hole regulation layer disposed between the active layer and the second window layer to regulate a speed at which the holes reach the active layer.

6. The light emitting module according to claim 5, wherein group III and group V elements constituting the first electron regulation layer are the same as group III and group V elements constituting the first hole regulation layer.

7. The light emitting module according to claim 1, further comprising:
a second cladding layer disposed between the active layer and the second window layer to prevent the electrons from crossing over into the second window layer.

8. The light emitting module according to claim 1, wherein an area of the first window layer is 0.7 to 1 times an area of the substrate.

9. The light emitting module according to claim 1, comprising a plurality of light emitting devices,
wherein the plurality of light emitting devices has respective peak wavelengths and a deviation between the respective peak wavelengths is 5 nm or less.

10. A light emitting module comprising:
a substrate; and
a plurality of light emitting devices disposed on the substrate, the plurality of light emitting devices comprising:
a first light emitting device comprising an active layer generating light having a peak wavelength of 600 nm or more;
a second light emitting device comprising an active layer generating light having a peak wavelength of less than 500 nm; and
a third light emitting device emitting light having a peak wavelength between the peak wavelength of the first light emitting device and the peak wavelength of the second light emitting device,
wherein group V elements constituting the first light emitting device are different from group V elements of the second and third light emitting devices, and
wherein a direction in which electrons are supplied to the active layer in the first light emitting device is the same as a direction in which electrons are supplied to the active layer in the second light emitting device.

11. The light emitting module according to claim 10, further comprising:
a reflective layer disposed on the substrate,
wherein the reflective layer is disposed around a periphery of at least some region of the plurality of light emitting devices and has a reflectivity of 80% or more with respect to the peak wavelengths of light emitted from the plurality of light emitting devices.

12. The light emitting module according to claim 10, wherein each of the light emitting devices further comprises a support substrate supporting the corresponding light emitting device, and light of different peak wavelengths emitted from the light emitting devices is emitted through the corresponding support substrates formed of the same material.

13. The light emitting module according to claim 12, further comprising:
a molding layer covering the plurality of light emitting devices and comprising a light exit surface,
wherein distances from the plurality of support substrates to the light exit surface are different from each other.

14. The light emitting module according to claim 13, further comprising:
an IC circuit or an IC driver,
wherein the IC circuit or the IC driver is electrically connected to the plurality of light emitting devices and covered by the molding layer simultaneously with the plurality of light emitting devices.

15. The light emitting module according to claim 14, wherein a height from an upper surface of the IC circuit or the IC driver to the light exit surface of the molding layer is different from a height from upper surfaces of the plurality of light emitting devices to the light exit surface of the molding layer, and the molding layer compensates for height difference such that the light exit surface is placed at the same location.

16. The light emitting module according to claim 12, wherein at least one of the light emitting devices comprises at least one light transmissive material disposed between the light emitting device and the support substrate to change an index of refraction.

17. The light emitting module according to claim 10, wherein the direction in which electrons are supplied to the active layer in the second light emitting device is the same as a direction in which electrons are supplied to the active layer in the third light emitting device.

18. The light emitting module according to claim 10, wherein a first type dopant material of the plurality of light emitting devices comprises at least one identical material.

19. The light emitting module according to claim 10,
wherein the first light emitting device comprises a first electron regulation layer disposed on one side of the active layer of the first light emitting device; and a first hole regulation layer disposed on the other side of the active layer of the first light emitting device, and
wherein group III and group V elements constituting the first electron regulation layer are the same as group III and group V elements constituting the first hole regulation layer.

20. The light emitting module according to claim 10, wherein the plurality of light emitting devices is individually controllable.
